# EUROPEAN PATENT SPECIFICATION

(11) **EP 2 195 822 B1**
(45) Date of publication and mention of the grant of the patent: **23.11.2011**
(21) Application number: 08835573.0
(22) Date of filing: 24.09.2008
(51) Int. Cl.: H01J 37/244, H01J 37/28

(54) **IONISATION DETECTOR FOR ENVIRONMENTAL SCANNING ELECTRON MICROSCOPE**
IONISATIONSDETEKTOR FÜR EIN ENVIRONMENTAL SCANNING ELECTRON MICROSCOPE
DÉTECTEUR D'IONISATION POUR ENVIRONMENTAL SCANNING ELECTRON MICROSCOPE

(30) Priority: 04.10.2007 CZ 20070685
(43) Date of publication of application: 16.06.2010
(73) Proprietor: Ustav Pristrojové Techniky Av Cr, V.v.i., 612 64 Brno (CZ)
(72) Inventor: NEDELA, Vilém, 664 34 Kurim (CZ); JIRÁK, Josef, 602 00 Brno (CZ)
(74) Representative: Markes, Libor
(86) International application number: PCT/CZ2008/000113
(87) International publication number: WO 2009/043317

(56) References cited:
- EP-B1- 0 958 591
- WO-A-98/40906
- US-A- 5 412 211
- US-A- 5 485 008
- US-A1- 2006 186 337
- US-A1- 2006 249 686

## Description

### Technical Field

This invention relates to an environmental scanning electron microscope including a specimen chamber separated from the pole piece of the microscope with pressure limiting apertures for pass of a beam of primary electrons and containing a sample holder and at least one detection electrode.

### Prior Art

In a scanning electron microscope a narrow beam of primary electrons with high energy falls on the examined sample. The primary electrons release from the surface layer of the sample secondary electrons with substantially lower energy. These secondary electrons carry information about the fine structure of the sample surface and are detected in the microscope. Part of the primary electrons return from the depth of the sample. These electrons are called backscattered electrons. Even though the backscattered electrons carry information about the sample, the information about the fine structure of the sample surface carried by the secondary electrons is affected rather negatively by them.

In standard electron microscopes the sample is located and observed in the specimen chamber with a vacuum. Also the whole trajectory of the primary electrons from the source to the sample and the complete trajectory of the secondary electrons from the sample to the sensor - detector - are in a vacuum. When examining samples containing substances evaporating in a vacuum, or electrical isolation samples, there are certain problems with standard microscopes. The sample is changed or destroyed in the vacuum as a result of the evaporation before its image is recorded. That is the reason for development of the so called environmental scanning electron microscopes allowing for sample examining in a gaseous environment under a pressure close to atmospheric pressure.

Environmental microscope construction causes most of the trajectory of the beam of the primary electrons from the source to the sample to be closed in a column with a pressure of at least 10⁻³ Pa. Before entrance to the specimen chamber there is one or more differentially pumped chambers with the pressure of single to tens of Pa, while the pressure in the specimen chamber amounts from hundreds to thousands of Pa. The primary electron beam passes through the aperture between the microscope column and the specimen chamber. Between this point and the sample a significant number of interactions of the electrons with the gaseous environment occur. The primary and the backscattered electrons cause the gas atom and molecule ionisation in the gaseous environment producing more electrons and positive ions. A similar ionisation is also caused by the secondary electrons. Further energy needed for continuation of the process of gas ionisation is supplied in the electric field of the ionisation detector to all electrically charged particles. The result is amplification of the signal coming from all of the abovementioned sources. The signals are detected by the electrode of the ionisation detector and contribute to creation of the sample image.

The ability to separate the signals coming from the secondary electrons from the signals of the backscattered or primary electrons or their products is an important task to be fulfilled by construction of effective detectors of secondary electrons for environmental scanning electron microscopes.

Solutions of this kind are subject of a number of patent documents. Patent US 5 362 964 describes an electrode integrated with a pressure limiting aperture at the entrance of the primary electron beam to the specimen chamber. The electrode is installed above a circular wire electrode under which the sample is placed. Secondary electrons emitted from the sample are detected by this circular wire electrode while the unwanted electrons generated by the collision of the backscattered electrons with the ambient environment are detected by the electrode integrated with the pressure limiting aperture. The resulting image is not created by the secondary electrons alone but by a mixture of secondary and backscattered electrons.

Patent application US2003010913 proposes acceleration of the secondary electrons emitted by the sample by the voltage difference between the sample and the pole piece for entry of the primary electron beam to the specimen chamber. This pole piece is surrounded with a secondary electrode with a positive potential in the shape of a reversed cone. Along its inner surface and in a ring around the pole piece there are other auxiliary electrodes, also with a positive potential. Between these electrodes and the pole piece there is a space with an electric field for control of the ionisation process of the accelerated secondary electrons whose result is recorded by the prime detection electrode installed on the "ceiling" of the specimen chamber in the space defined by the secondary electrode.

In the environmental scanning electron microscopes described in the abovementioned documents, as well as in all known microscopes of this kind, the active side of the detection electrode faces away from the approaching primary electrons, or towards the secondary electrons emitted from the sample. Despite all the measures proposed by the abovementioned and other documents it is impossible to completely eliminate influence of the backscattered electrons and electrons produced by collisions of the backscattered electrons on the resulting image.

US 5,485,008 describes a variant of the differentially pumped chamber of the environmental scanning electron microscope, whose bottom, pressure limiting aperture forms part of the detector. The detector, however, may also be implemented in the shape of an annulus with the bottom, the top and the side surface active, located on the cylindrical wall around the sample made of insulating material. The location of the detector can be varied i.a. below or above the specimen. A positive voltage is on the detector in such case, as shown by US 4,785,182.

US2006/0183667 A1 discloses an SEM with i.a. the following: In the detection system, a mesh type doughnut-shaped electric field supply electrode encompassing the sample and a sheet-like doughnut-shaped ion current detection electrode (typically, having a bracket shape) covering the doughnut-shaped electric field supply electrode are used as the electric field supply electrode and the ion current detection electrode. The doughnut-shaped electric field supply electrode and the doughnut-shaped ion current detection electrode are fixed to the sample holder. A positive voltage and a negative voltage are applied to the doughnut-shaped electric field supply electrode and the doughnut-shaped ion current detection electrode, respectively, to let the secondary electrons drift towards the doughnut-shaped electric field supply electrode and to generate the electron avalanche in the proximity of the mesh wires of the doughnut-shaped electric field supply electrode. An auxiliary electrode interposed between the doughnut-like electric field supply electrode and the sample holder is mesh-like encompassing the sample. A positive voltage lower than the voltage of the voltage supply electrode is applied to the auxiliary electrode to accelerate the secondary electrons towards the doughnut-shaped electric field supply electrode. The ions amplified by the electron avalanche are attracted towards the current detection electrode by the electric field and are detected as the ion current from this electrode.

The present invention aims at proposal of a complex design of a detector for an environmental scanning electron microscope providing for higher quality of the image by means of detection of the signal of the secondary electrons with minimum contribution from the other signals, and in the case of the secondary electrons the electron detection in relation to their energy and direction and control of the recombination process of the secondary electrons with positive ions that may negatively affect the secondary electron signal amplification.

### Summary of the Invention

The abovementioned tasks designs an environmental scanning electron microscope including a specimen chamber separated from the pole piece of the microscope with a pressure limiting aperture for pass of a primary electron beam and equipped with a sample holder wherein a flat detection electrode, whose active side faces the incoming primary electron beam, surrounds the sample substantially in the sample plane or under it. For the purpose of reversing the trajectories of secondary electrons towards this electrode, the detection electrode is - in the sense of the primary electron flow - preceded by at least one retarding electrode in the shape of a grid to which controlled negative voltage is independently supplied.

For the purpose of elimination of the electrons reflected from the metal parts of the specimen chamber a suction electrode may be placed before the retarding electrode with positive or negative voltage in a close proximity to the pole piece of the microscope.

The best variant is a suction electrode made as a conductive layer on the bottom side of a scintillation single crystal, with a hole for the primary electron beam with a small-diameter opening.

For reinforcement of the effects of the retarding electrode it is convenient to install a ring electrode surrounding the sample with adjustable position in relation to the sample and with controlled positive or negative voltage.

The sample holder may be a cylindrical electrode with the option of grounding or connection of controlled positive or negative voltage.

The signal of the secondary electrons detected by the detecting electrode may be amplified in certain cases by extension of the length of the electron trajectory in the gaseous environment. For that purpose the sample holder is surrounded with a magnetic circuit allowing for creation of a magnetic field with variable intensity around the sample open to the specimen chamber.

The detection electrode may be constructed as consisting of sectors with separate evaluation circuits or as consisting of annuluses. This allows for detection of the secondary electrons in relation to their energy and direction.

The position of the detection electrode may be adjustable in relation to the sample plane.

### Brief Description of the Drawings

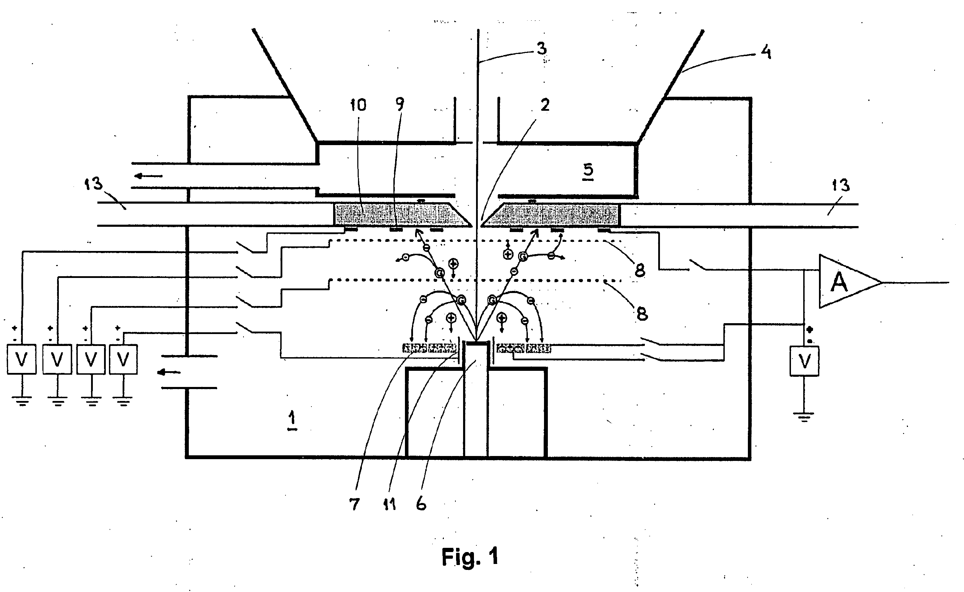

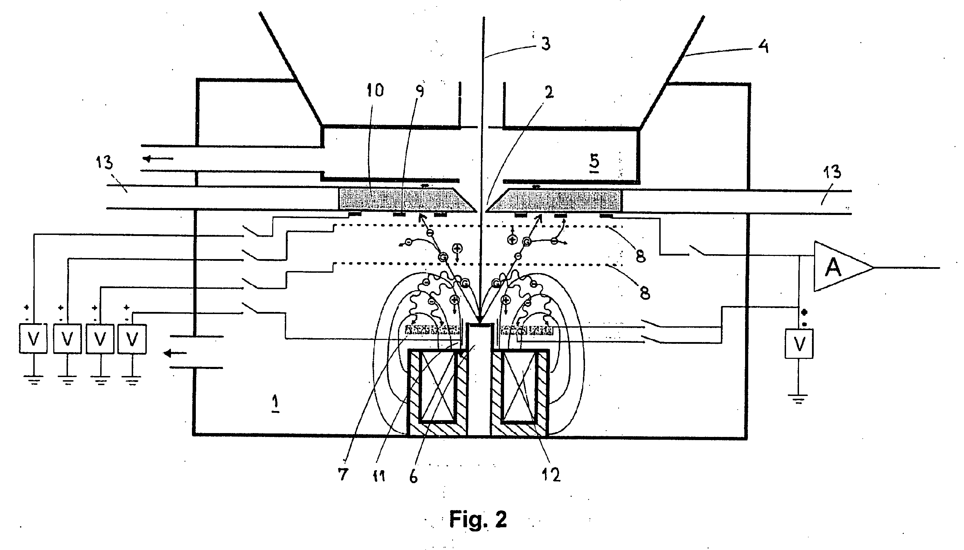

The invention will be further elucidated with a drawing whose FIG. 1 shows an exemplary scheme of a ionisation detector of an environmental scanning electron microscope whose sample holder is not provided with a magnetic circuit while the version shown in FIG. 2 does contain this magnetic circuit.

### Detailed Description of Preferred Embodiments

An environmental scanning electron microscope consists of a specimen chamber 1 separated with an pressure limiting aperture 2 for pass of a primary electron beam **3** from a pole piece **4** of the microscope. The pole piece **4** includes a differentially pumped chamber **5**. The specimen chamber **1** contains a cylindrical sample holder **6** surrounded with a flat detection electrode **7** of the rotational symmetrical type with the symmetry centre in the centre of the sample holder **6**. As a rule the plane of this detection electrode **7** is identical with the sample plane or under it in another version. The active side of the detection electrode **7** is facing the incoming primary electron beam **3**.

For the purpose of reversing the trajectory of the secondary electrons towards the detection electrode **7** the detection electrode **7** is preceded (in the sense of the primary electron flow) with retarding electrodes **8** parallel to the detection electrode in the shape of grids with independently supplied controlled negative voltage. In the described examples the retarding electrode **8** is further preceded by a suction electrode **9** supplied with positive voltage. The suction electrode **9** is situated in a close proximity to the pole piece **4** of the microscope and its function is elimination of the electrons reflected by the metal parts of the specimen chamber **1**. The suction electrode **9** is formed with a conductive layer on the bottom side of a structured scintillation single crystal **10** with a small hole acting as the pressure limiting aperture **2** for the primary electron beam **3** to pass. For the purpose of reinforcement of the effects of the retarding electrode **8** the sample is further surrounded with an installed ring electrode **11** whose vertical position is adjustable in relation to the sample and which is supplied with controlled positive or negative voltage. The sample holder **6** consists of a cylindrical electrode with the option of grounding or connection of controlled positive or negative voltage. The detection electrode **7** may be divided for example into concentric annuluses connected to separate detector pre-amplifiers each (as in the present example). Another version of the electrode consists of sectors connected to separate detector pre-amplifiers each.

The version shown in FIG. 2 in addition amplifies the detected secondary electron signal received by the detecting electrode **7** by surrounding the sample holder **6** with a magnetic circuit **12** with controlled electromagnetic field intensity. The electromagnetic field is open towards the specimen chamber **1**.

The light signal of the scintillation single crystal is transported for evaluation by light guides **13**. The arrows show air pumping from the differentially pumped chamber **5** and from the specimen chamber **1**. Electrodes **7**, **8**, **9**, **11** and the sample holder **6** are connected to separate voltage sources **V**. The suction electrode **9** is preceded with a pre-amplifier A. As a consequence of the primary electron beam **3** interaction with the sample, the sample emits electrons Θ. These electrons are backscattered electrons Θ and secondary electrons Θ. Their interaction with gas atoms or molecules **G** cause ionisation and generation of further electrons Θ and positive ions ⊕, as shown in both figures. With the magnetic circuit on - see FIG. 2 - the route of the secondary electrons Θ is shaped into a spiral, which elongates the trajectory and reinforces the ionisation effect.

The detection electrode **7** is connected to the positive potential of a floating source with adjustable level of positive voltage of hundreds of volts and to the pre-amplifier **A** of the detector, evaluating changes of the current flow through this electrode **7**. The changes of the current flow form the basic variable of the function of image brightness modulation. The detection electrode **7** may be constructed as divided into sectors or concentric annuluses of different diameters. In the case of the sectors the secondary electron Θ signal distribution may be studied on the basis of the spatial angle. In the case of the concentric annuluses - more electrodes with different diameters - it is possible to simultaneously or separately record the energy separated electron signals.

Electrostatic field in the specimen chamber 1 is co-created by separation electrodes, which include retarding electrodes, a suction electrode and a ring electrode, **8**, **9** and **11**, see FIG. 1. For the reason of minimisation of the effect of secondary electrons Θ generated after the backscattered electrons impacting the metal parts of the microscope on the detected signal it is recommended to cover the electrodes **8**, **9** and **11** with at least 50µm layer of carbon. The ring electrode **11** is installed between the detection electrode **7** and the sample and is not conductively connected with the other electrodes. The position of the ring electrode **11** may be arbitrarily altered along Z axis, which allows its setting to positions above the sample plane, in the sample plane or under the sample plane. Positive or negative voltage - amounting to single to tens of volts - is supplied to the electrode **11** from an independent voltage source. The retarding electrode **8** consists one or two grids installed in the space between the sample and the pole piece **4** of the microscope lenses. The retarding electrode **8** is conductively isolated from the grounding of the microscope and the other electrodes and is supplied with negative voltage amounting to single to tens of volts.

In the detector configuration shown by FIG. 1 the suction electrode **9** is implemented with a thin conductive layer applied on the surface of the structured scintillation single crystal **10**, at the same time used as a pressure limiting aperture **2** of the differentially pumped chamber **5** and as part of the scintillation-photo-multiplier variant of the backscattered electron detectors. The suction electrode **9** may also be implemented as a separate conductively separated electrode installed above the retarding electrode **8** and immediately under the pole piece **4**, or under the differentially pumped chamber **5** of microscope. This electrode **8** is connected to a source of positive or negative voltage amounting to single to tens of volts. In the simplest case, with the detection and the ring electrodes **7**, **11** disconnected and the retarding electrode **8** absent, it is possible to connect the suction electrode **8** with the pre-amplifier **A** and the source of positive voltage **V** and thus create the basic variant of the ionisation detector, described in literature as environmental secondary detector (ESD).

The sample holder **6** is situated in the centre of the rotational symmetry of the detector system and consists of a cylindrical electrode. The electrode may be conductively connected with the microscope grounding and perform the function of the sample grounding system, or floating and connectable to the positive or the negative voltage source. The sample holder **6** also includes an open magnetic circuit **12** generating directed electromagnetic field with sufficient intensity, see FIG. 2.

The detector is equipped with the above described system of electrodes whose schematic layout is shown in FIG. 1. Depending on the particular detector configuration, not all of the electrodes may be used and they may also differ in the size or polarity of the voltage fed to them.

The basic detector configuration just uses the detection electrode **7**, the ring electrode **11** and the suction electrode **9**, the latter electrode **9** substitution for the function of the retarding electrode **8** in this case. After interaction of the primary electron beam **3** with the sample the sample emits secondary electrons Θ across the energy spectrum up to the energy of the primary electrons.

The high-energy backscattered electrons moving in high speeds along straight routes away from the sample under a spatial angle of 0 to 180 deg. can neither hit the detection electrode **7** because of its position nor be caught by the electrostatic field of the detection electrode **7** supplied with positive voltage amounting to hundreds of volts. This eliminates the presence of the backscattered electrons in the detected signal. The backscattered electrons therefore continue along their straight paths towards the scintillation single crystal **10** as the basic element of the scintillation-photo-multiplier variant of the backscattered electron detector. Thanks to this configuration it is recommended to combine the above described detector with the single crystal backscattered electron detector.

The low-energy secondary electrons Θ with the energy of up to 50eV emitted from the sample under the spatial angle of 0 to 180 deg. are deflected with the electrostatic field of the suction electrode **9** with negative voltage, and the ring electrode **11** with positive voltage, towards the space above the detection electrode **7**.

If negative voltage is supplied to the ring electrode **11** the electrode **11** may be used for control of the recombination processes between the electrons and the positive ions ⊕. The control is implemented by the electrode **11** catching the positive ions ⊕ thus reducing their number. This is positively reflected on the level of the detected signal.

The secondary electrons Θ present in the space above the detection electrode **7** are caught by the strong electrostatic field of the electrode **7**. The resulting shape of the trajectory of the secondary electrons Θ depends on their energy and intensity of the electrostatic fields of the detector electrodes. The trajectory may be elongated or shortened by them. Thanks to this effect the detected electrons may be filtered on the basis of their energy. The electrons with energy higher than required move along less curved trajectories and fall on the more distant segments of the detecting electrode **7**, i.e. the segments of higher diameters, or miss the detecting electrode completely. On the other hand the electrons with the required energy are focused on the inside segments of the detecting electrode **7**, i.e. the segments of smaller diameters.

Extension of the secondary electron Θ trajectories with preserved short working distance of the sample from the pole piece **4** of the microscope allows for maximisation of the effect of cascade multiplication of the secondary electrons Θ in the space between the sample and the detection electrode **7**. At the same time dispersion of the primary electrons on their short trajectories from the pole piece **4** towards the sample is minimised.

Supply of negative voltage on the sample may further increase detection efficiency of this detector. The low-energy secondary electrons Θ with energy around 5eV are not sufficiently energised for the ionisation process generating another electron and a positive ion ⊕ as a consequence of the interaction between the secondary electron and an atom or a molecule of the gas filling the chamber. The negative potential on the sample allows for increase of energy of these low-energy electrons, optimisation of the ionisation process and increase of the number of the detected secondary electrons Θ. For that reason the detector is able to detect energy selective signal of the secondary electrons Θ with very high efficiency.

The detector variant with the retarding electrode **8** represents an optimised detector variant allowing for minimisation of the effect of secondary electrons Θ generated after the backscattered electrons impact the metal parts of the microscope or the detectors and the electrons resulting from the interaction of the backscattered electrons and the gas atoms or molecules in the detected signal. The high-energy backscattered electrons are not affected by the electrostatic field of the retarding electrode **8** supplied with negative voltage. These electrons pass through the grid and hit the scintillation single crystal **10**, whose surface is covered with a thin conductive layer of the suction electrode with positive voltage. The secondary electrons Θ resulting from the contact of the backscattered electrons and the metal parts of the microscope or the electrodes are caught by the suction electrode **9** and thus are prevented from hitting the detection electrode **7**. The backscattered electrons whose energy is reduced after their passing through the high-pressure environment of the specimen chamber **1** of the microscope and the electrostatic field of the retarding grid generate an increased number of secondary electrons Θ in the space above the retarding electrode **8**. These electrons result from the interactions of the backscattered electrons and the gas atoms and molecules and their presence in the detected signal is undesirable. That is why they are caught by the electrostatic field of the suction electrode **9**, whose efficacy is further multiplied by the electrostatic field of the retarding electrode **8** supplied with negative voltage. The electrostatic field of the retarding electrode **8** also catches the generated positive ions ⊕, whose presence lowers the number of the detectable secondary electrons Θ in the detector. Detection of the secondary electrons Θ follows the same procedure as described for the detector without the retarding electrode **8**.

The detected secondary electron Θ signal received by the detecting electrode 7 may further be amplified by the effect of the magnetic field of the open magnetic circuit **12**, see FIG. 2. Magnetic field with a sufficient intensity causes spiral movement of the secondary electrons Θ, whose speed vector is oriented in a non-zero angle, or ideally is perpendicular to the magnetic induction vector. Thanks to that the trajectory of the secondary electrons Θ from the sample to the detecting electrode **7** is even more elongated. The electron trajectory elongation causes increased number of electron interactions with the gas atoms and molecules and thus increase efficacy of the cascade multiplication of the electrons hitting the detecting electrode **7**.

## Claims

1. An environmental scanning electron microscope including a specimen chamber (1) separated from the pole piece (4) of the microscope with a pressure limiting aperture (2) for pass of a primary electron beam (3) and equipped with a sample holder (6) wherein a flat detection electrode (7), whose active side faces the incoming primary electron beam (3), surrounds the sample substantially in the sample plane or under it, and wherein the detection electrode (7) is in the sense of the primary electron flow-preceded by at least one retarding electrode (8) in the shape of a grid to which controlled negative voltage is independently supplied.

2. The microscope of claim 1, wherein the retarding electrode (8) is preceded, in the sense of the primary electron flow, with a suction electrode (9) fed with positive or negative voltage and installed immediately next to the pole piece (4) of the microscope.

3. The microscope of claim 2, wherein the suction electrode (9) is made as a conductive layer applied to the bottom side of a scintillation single crystal (10), with a pass for the primary electron beam (3).

4. The microscope of claims 1 to 3, wherein the detector is provided with a ring electrode (11) surrounding the sample whose position is adjustable in relation to the sample and which is supplied with controlled positive or negative voltage.

5. The microscope of claims 1 to 4, wherein the sample holder (6) consists of a cylindrical electrode that is either earthed or connected to a source of controlled positive or negative voltage.

6. The microscope of claims 1 to 5, wherein the sample holder (6) is surrounded with a magnetic circuit (12) with controlled intensity of the electromagnetic field, open to the specimen chamber (1).

7. The microscope of claims 1 to 6, wherein the detection electrode (7) is divided to individual sectors connected each to a separate evaluation circuit.

8. The microscope of claims 1 to 7, wherein the detection electrode (7) is divided to annuluses connected each to a separate evaluation circuit.

9. The microscope of claims 1 to 8, wherein the position of the detection electrode (7) is adjustable in relation to the sample plane.

## Patentansprüche

1. Environmentales Rasterelektronenmikroskop, das eine Objektkammer (1) enthält, die von einem Polstück (4) des Mikroskops durch eine Druck limitierende Blende (2) für den Durchgang eines Primärelektronenstrahls (3) getrennt und mit einer Objekthalterung (6) versehen ist, **dadurch gekennzeichnet, dass** eine flache Detektionselektrode (7), deren aktive Seite einem Strahl (3) der ankommenden Primärelektronen zugewandt ist, das Objekt im Wesentlichen auf der Objektebene oder darunter umkreist, wobei der Detektionselektrode (7) zumindest eine gitterförmige, mit gesteuerter negativer Spannung gespeiste Retardierungselektrode (8) im Sinne des Primärelektronenflusses vorausgeht.

2. Mikroskop nach Anspruch 1, **dadurch gekennzeichnet, dass** der Retardierungselektrode (8) eine Saugelektrode (9) im Sinne des Primärelektronenflusses vorausgeht, die in der Nähe des Polstücks (4) des Mikroskops positioniert und mit positiver oder negativer Spannung gespeist ist.

3. Mikroskop nach Anspruch 2, **dadurch gekennzeichnet, dass** die Saugelektrode (9) als eine konduktive Schicht an der unteren Seite eines Scintillation-Monokristalls (10) gebildet ist, der mit einer Apertur für den Primärelektronenstrahl (3) versehen ist.

4. Mikroskop nach Ansprüchen 1 bis 3, **dadurch gekennzeichnet, dass** der Detektor mit einer das Objekt umkreisenden Ringelektrode (11) versehen ist, deren Lage gegenüber dem Objekt einstellbar ist, und die mit gesteuerter positiver oder negativer Spannung gespeist ist.

5. Mikroskop nach Ansprüchen 1 bis 4, **dadurch gekennzeichnet, dass** die Objekthalterung (6) durch eine zylinderförmige Elektrode gebildet ist, die entweder geerdet oder an eine Quelle der gesteuerten positiven oder negativen Spannung angeschlossen ist.

6. Mikroskop nach Ansprüchen 1 bis 5, **dadurch gekennzeichnet, dass** die Objekthalterung (6) mit einem magnetischen Kreis (12) mit gesteuerter Intensität des elektromagnetischen Feldes umkreist ist, das in die Objektkammer (1) geöffnet ist.

7. Mikroskop nach Ansprüchen 1 bis 6, **dadurch gekennzeichnet, dass** die Detektionselektrode (7) in einzelne Sektorflächen geteilt ist, von denen jede an eine separate Auswerteschlatung angeschlossen ist.

8. Mikroskop nach Ansprüchen 1 bis 7, **dadurch gekennzeichnet, dass** die Detektionselektrode (7) in einzelne Kreisringe geteilt ist, von denen jeder an eine separate Auswerteschlatung angeschlossen ist.

9. Mikroskop nach Ansprüchen 1 bis 8, **dadurch gekennzeichnet, dass** die Lage der Detektionselektrode (7) gegenüber der Objektebene verstellbar ist.

## Revendications

1. Un microscope électronique environnemental à quadrillage dont une partie composante est une chambre (1) qui est séparée d'une cosse polaire (4) du microscope par une diaphragme (2) limitante la pression pour le passage d'un faisceau (3) des électrons primaires et munie d'un porte échantillons (6), **caractérisé en ce que** une électrode (7) plate de détection dont son côté active est orienté contre le rayon (3) des électrons arrivant entoure l'échantillon en principe dans le plan de l'échantillon ou au-dessous de ce plan, cependant en amont de l'électrode de détection (7) est - dans le sens du flux des électrons primaires - superposée au minimum une électrode retardatrice (8) en forme d'une grille qui est indépendamment alimentée par la tension réglée négative.

2. Le microscope selon la revendication 1, **caractérisé en ce que** en amont de l'électrode retardatrice (8) est, dans le sens du flux des électrons primaires, superposée une électrode d'extraction (9) alimentée par la tension positive ou négative et située dans la proximité immédiat de la cosse polaire (4) du microscope.

3. Le microscope selon la revendication 2, **caractérisé en ce que** l'électrode d'extraction (9) est façonnée comme la couche conductrice à la face inférieure d'un mono-crystal de scintillation (10), avec le passage pour le rayon (3) des électrons primaires.

4. Le microscope selon les revendications 1 à 3, **caractérisé en ce que** le détecteur est muni d'une électrode annulaire (11) entourant l'échantillon dont la position vis-à-vis de l'échantillon est réglable et qui est alimentée par la tension réglée positive ou négative.

5. Le microscope selon les revendications 1 à 4, **caractérisé en ce que** le porte échantillons (6) est créé par une électrode cylindrique qui est soit mise à la terre, ou connectée à une source de la tension réglée positive ou négative.

6. Le microscope selon les revendications 1 à 5, **caractérisé en ce que** le porte échantillons (6) est entouré par un circuit magnétique (12) avec le réglage d'intensité du champ électromagnétique ouvert dans la chambre (1) d'échantillon.

7. Le microscope selon les revendications 1 à 6, **caractérisé en ce que** l'électrode de détection (7) est divisée en secteurs de cercle dont chacun est connecté à un circuit indépendant d'évaluation.

8. Le microscope selon les revendications 1 à 6, **caractérisé en ce que** l'électrode de détection (7) est divisée en couronnes de cercle dont chacune est connectée à un circuit indépendant d'évaluation.

9. Le microscope selon les revendications 1 à 8, **caractérisé en ce que** la position de l'électrode de détection (7) est ajustable vis-à-vis du plan d'échantillon.
